# EUROPEAN PATENT APPLICATION

(11) **EP 4 675 870 A1**
(43) Date of publication of application: **07.01.2026**
(21) Application number: 24763455.3
(22) Date of filing: 29.01.2024
(51) Int. Cl.: H01S 5/02325, H01S 5/02255, H01S 5/02326

(54) **OPTICAL DEVICE**

(30) Priority: 27.02.2023 JP 2023028044
(71) Applicant: FURUKAWA ELECTRIC CO., LTD., Tokyo 100-8322 (JP); NICHIA CORPORATION, Anan-shi, Tokushima 774-8601 (JP)
(72) Inventor: SHIBUYA, Satoshi, Tokyo 100-8322 (JP); TSUKIJI, Naoki, Tokyo 100-8322 (JP); HAYAMIZU, Naoki, Tokyo 100-8322 (JP); TANAHASHI, Yasuo, Anan-shi, Tokushima 774-8601 (JP)
(74) Representative: SSM Sandmair
(86) International application number: PCT/JP2024/002609
(87) International publication number: WO 2024/180970

(57) **Abstract**

An optical device includes, for example, a base including a first face facing in a first direction; an optical component having a second face that faces the first face and that is adhered to the first face with an adhesive; and an inhibitor that inhibits part of laser light an optical axis of which is out of alignment with the optical component from reaching the adhesive. The optical device may include a first inhibitor that inhibits the laser light from entering the optical component as the inhibitor or may include a first reflector that reflects the laser light in a direction not toward the adhesive as the first inhibitor. The first reflector may be provided on a third face that is positioned at an end of the optical component in a direction opposite to a direction in which the laser light travels and may have a reflective film that is provided on the third face.

## Description

### Field

The present invention relates to an optical device.

### Background

An optical device that includes a plurality of mirrors fixed onto a base and that is configured such that laser light reflected on a different mirror passes a position that is above each mirror and that is separate from the mirror has been known (for example, Patent Literature 1). As for this type of optical devices, mirrors are fixed to a base with an adhesive in many cases.

### Citation List

### Patent Literature

Patent Literature 1: International Publication Pamphlet No. WO 2017/134911

### Summary

### Technical Problem

In this type of optical devices, the center of an optical axis of laser light is set separate from a mirror such that the laser light interferes with the mirror as little as possible. Laser light however has a spread on the optical axis and therefore there is a risk that, in a region where the distance between the mirror and the optical axis is short because of a production tolerance, or the like, an amount by which part of an outer periphery of the laser light interferes with the mirror will increase. It was proved that the, in that case, there is a risk that the interfering laser light will scatter on an outer surface of the mirror, will be transmitted through the mirror and reach an adhesive, and the laser light will change the adhesive in quality.

An object of the present invention is to obtain an optical device that has a more improved and new configuration and that makes it possible to inhibit an adhesive that adheres an optical component, such as a mirror, and a base from changing in quality.

### Solution to Problem

An optical device according to the present invention includes, for example, a base including a first face facing in a first direction, an optical component having a second face that faces the first face and that is adhered to the first face with an adhesive, and an inhibitor that inhibits part of laser light an optical axis of which is out of alignment with the optical component from reaching the adhesive.

In the optical device, a first inhibitor that inhibits the laser light from entering the optical component may be provided as the inhibitor.

In the optical device, a first reflector that reflects the laser light in a direction not toward the adhesive may be provided as the first inhibitor.

In the optical device, the first reflector may be provided on a third face that is positioned at an end of the optical component in a direction opposite to a direction in which the laser light travels.

In the optical device, the first reflector may have a reflective film that is provided on the third face.

In the optical device, the first reflector may reflect the laser light in a direction intersecting with a direction opposite to a direction in which the laser light travels.

In the optical device, the first reflector may be provided on a first part that is attached to the base.

In the optical device, the first part may be attached to the first face.

The optical device may include a fourth face facing in the first direction at a position out of alignment in a direction opposite to a direction in which the laser light travels with respect to the first face, and the first part may be attached to the fourth face.

In the optical device, an absorber that absorbs the laser light may be provided as the first inhibitor.

In the optical device, the absorber may be provided on a third surface that is positioned at an end of the optical component in a direction opposite to a direction in which the laser light travels.

In the optical device, the absorber may be provided on a second part that is attached to the base.

In the optical device, the first inhibitor may be provided on a protrusion that is part of the base and that protrudes from the base.

In the optical device, a second inhibitor that is provided on a fifth face on which the laser light enters the optical component and that inhibits laser light from scattering may be provided as the inhibitor.

In the optical device, a third inhibitor that inhibits the laser light from being transmitted to the adhesive in the optical component when the laser light enters the optical component may be provided as the inhibitor.

In the optical device, as the third inhibitor, a third inhibitor provided on a back surface of a reflective film that covers a sixth face serving as an outer surface of the optical component is provided.

In the optical device, a second reflector that reflects laser light that enters the optical component in a direction not toward the adhesive may be provided as the third inhibitor.

In the optical device, in a seventh face that serves as an outer surface of the optical component and that transmits the laser light toward the sixth face, a first area having higher transmissivity to the laser light than other outer surfaces of the optical component may be provided.

In the optical device, a reflective-preventive film may be provided in the first area.

In the optical device, the first area may be an area having a surface roughness lower than other outer surfaces.

In the optical device, a plurality of first optical components may be provided as the optical component, a plurality of faces that are out of alignment in a direction in which the laser light travels and that form steps that are output alignment in a direction opposite to the first direction toward the direction in which the laser light travels may be provided as the first face, and the optical axis may be out of alignment in the first direction with respect to the plurality of faces.

### Advantageous Effects of Invention

According to the present invention, for example, it is possible to obtain an optical device having a more-improved and new configuration that makes it possible to inhibit an adhesive that adheres an optical component and a base from changing in quality.

### Brief Description of Drawings

FIG. 1 is an exemplary and schematic plane view of an optical device of an embodiment.
FIG. 2 is an exemplary and schematic perspective view of a base that is contained in the optical device of the embodiment.
FIG. 3 is an exemplary and schematic side view of a subunit that is contained in the optical device of the embodiment.
FIG. 4 is an exemplary and schematic plane view of part of an optical device of a first embodiment.
FIG. 5 is an exemplary and schematic side view (partial cross-sectional view) of part of the optical device of the first embodiment.
FIG. 6 is a side view (partial cross-sectional view) of part of an optical device of a second embodiment viewed in a direction equal to a Da-direction in FIG. 4.
FIG. 7 is a side view (partial cross-sectional view) of part of an optical device of a third embodiment viewed in a direction equal to the Da-direction in FIG. 4.
FIG. 8 is an exemplary and schematic plane view of part of an optical device of a fourth embodiment.
FIG. 9 is an exemplary and schematic side view (partial cross-sectional view) of part of the optical device of the fourth embodiment.
FIG. 10 is a side view (partial cross-sectional view) of part of an optical device of a fifth embodiment viewed in a Db direction in FIG. 8.
FIG. 11 is an exemplary and schematic plane view of part of an optical device of a sixth embodiment.
FIG. 12 is an exemplary and schematic side view (partial cross-sectional view) of part of the optical device of the sixth embodiment.
FIG. 13 is a side view of part of an optical device of a seventh embodiment viewed in a direction equal to the Da-direction in FIG. 4.
FIG. 14 is a side view (partial cross-sectional view) of part of an optical device of an eighth embodiment viewed in a direction equal to the Da-direction in FIG. 4. Description of Embodiments

Exemplary embodiments of the present invention will be disclosed below. The configurations of the embodiments presented below and the operations and the results (effects) caused by the configurations are examples. The present invention can be realized by ones other than the configurations disclosed in the embodiments below. According to the present invention, it is possible to obtain at least one of various effects (including derivative effects) obtained because of the configurations.

The embodiments presented below have similar configurations. Thus, according to each of the embodiments, the same functions and effects as those based on the similar configurations are obtained. Similar numerals are assigned to the similar configurations and redundant description is sometimes omitted below.

In the specification, ordinal numbers are assigned for convenience in order to distinguish directions, regions, parts, etc., and do not represent priorities and orders and do not specify numbers.

In each of the drawings, a X1-direction is represented by an arrow X1, a X2-direction is represented by an arrow X2, a Y-direction is represented by an arrow Y, and a Z-direction is represented by an arrow Z. The X1-direction, the Y-direction and the Z-direction intersect with one another and are orthogonal to one another. The X1-direction and the X-2 direction are directions opposite to each other.

### First Embodiment

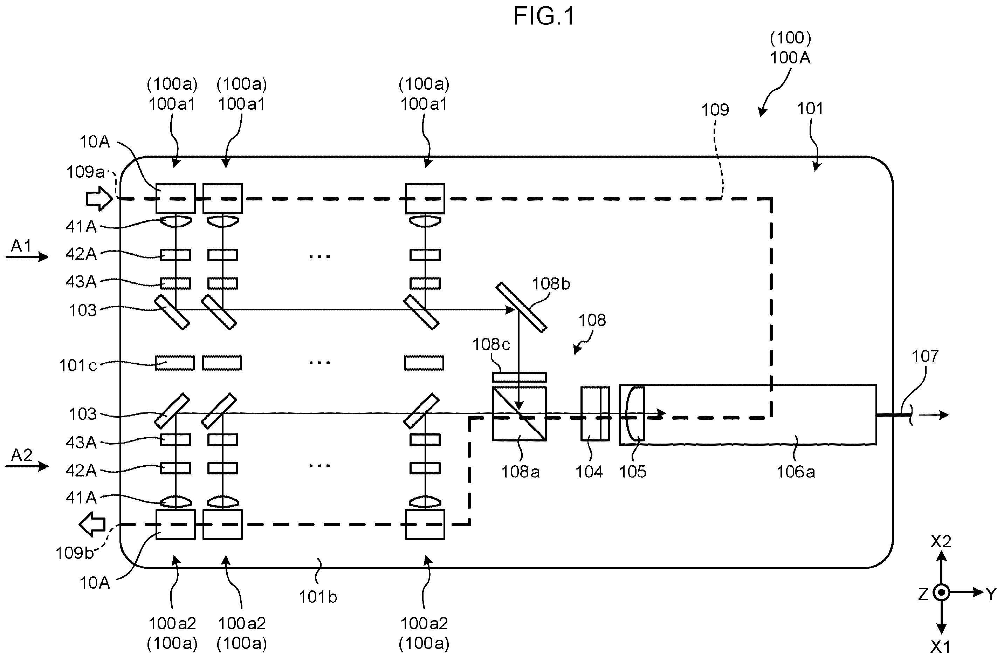

FIG. 1 is a schematic configuration diagram of an optical device 100A (100) of a first embodiment and is a plane view of the inside of the optical device 100A (100) viewed in a direction opposite to the Z-direction.

As illustrated in FIG. 1, the optical device 100 includes a base 101, a plurality of subunits 100a, an optical synthesizer 108, condenser lenses 104 and 105, and an optical fiber 107. Laser light that is output from a light-emitting module 10A of each subunit 100a is transmitted to an end (not illustrated in the drawing) of the optical fiber 107 via z of each subunit 100a, the optical synthesizer 108, and the condenser lenses 104 and 105 and is coupled optically with the optical fiber 107. The optical device 100 is also referred to as a light emitting device.

The base 101, for example, is made of a material having high thermal conductivity, such as a copper material or an aluminum material. The base 101 may be composed of component or may be composed of a plurality of components. The base 101 is covered with a cover (not illustrated in the drawing). The subunits 100a, a plurality of mirrors 103, the optical synthesizer 108, the condenser lenses 104 and 105, and the end of the optical fiber 107 are all provided on the base 101 and are housed in room for housing formed between the base 101 and the cover. The room for housing is airtight.

The optical fiber 107 is an output optical fiber and is fixed to the base 101 via a fiber supporter 106a that supports the end of the optical fiber 107.

The fiber supporter 106a may be configured as part of the base 101 integrally with the base 101 and the fiber supporter 106a that is configured as a component different from the base 101 may be attached to the base 101 via, for example, a holder, such as a screw.

Each of the subunits 100a includes the light-emitting module 10A that outputs laser light, a plurality of lenses 41A to 43A, and a mirror 103. A lens 42A collimates laser light on a fast axis and a lens 42B collimates laser light on a slow axis. The lenses 41A to 43A and the mirror 103 are an example of optical components.

The optical device 100 includes two arrays A1 and A2 on which the subunits 100a are aligned at given intervals in the Y-direction. In the subunit 100a1 (100a) of the array A1, the light-emitting module 10A outputs laser light in the X1-direction, the lenses 41A to 43A transmit the laser light from the light-emitting module 10A in the X1-direction, and the mirror 103 reflects the laser light traveling in the X1-direction to the Y-direction. In the subunit 100a1 (100a) of the array A2, the light-emitting module 10A outputs laser light in the X2-direction, the lenses 41A to 43A transmit the laser light from the light-emitting module 10A in the X2-direction, and the mirror 103 reflects the laser light traveling in the X2-direction to the Y-direction.

In the present embodiment, the subunit 100a1 of the array A1 and the subunit 100a2 of the array A2 are aligned in the X1-direction (X2-direction). Note that a shield 101c that shields stray light (leaking light) is provided between the subunit 100a1 and the subunit 100a2. As described above, when the subunit 100a1 and the subunit 100a2 are aligned in the X1-direction, for example, an advantage that the size of the optical device 100 in the Y-direction more decreases is obtained. Note that, not limited to this, the subunit 100a1 and the subunit 100a2 may be out of alignment. For example, each subunit 100a2 may be aligned in the X1-direction with respect to a gap between two subunits 100a1 adjacent to each other in the Y-direction.

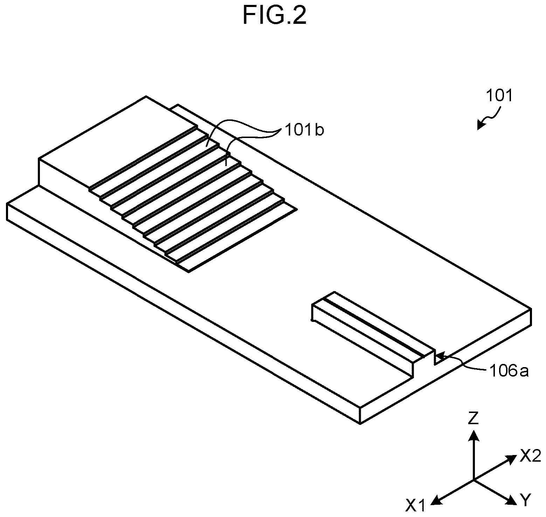

FIG. 2 is a perspective view of the base 101. As illustrated in FIG. 2, a plurality of faces 101b of the base 101 form steps on which the positions of the subunits 100a are out of alignment in the direction opposite to the Z-direction along the Y-direction. In each of the arrays A1 and A2 on which the subunits 100a are aligned in the Y-direction at given intervals (for example, certain intervals), the subunits 100a are arranged on the respective faces 101b. Accordingly, the positions of the subunits 100a contained in the array A1 in the Z-direction are out of alignment in the direction opposite to the Z-direction along the Y-direction and the positions of the subunits 100a contained in the array A2 in the Z-direction are also out of alignment in the direction opposite to the Z-direction along the Y-direction. Such a configuration makes it possible to, on each of the arrays A1 and A2, input sets of laser light traveling in the Y-direction, aligned in the Z-direction, and parallel to each other from the mirrors 103 to the optical synthesizer 108. Note that the faces 101b may be out of alignment in a direction of a slope in the Y-direction or the direction opposite to the Y-direction with respect to the Z-direction and may be configured such that laser light travels from each mirror 103 in a direction with a given angle of elevation to the Y-direction.

As illustrated in FIG. 1, laser light from each mirror 103 is input to the optical synthesizer 108 and may be synthesized in the optical synthesizer 108.

The optical synthesizer 108 includes a combiner 108a, a mirror 108b, and a 1/2 wave plate 108c. The combiner 108a, the mirror 108b, and the 1/2 wave plate 108c are an example of the optical component.

The mirror 108b causes the laser light from the subunit 100a of the array A1 to travel toward the combiner 108a via the 1/2 wave plate 108c. The 1/2 wave plate 108c rotates a polarization surface of the light from the array A1.

The laser light from the subunit 100a of the array A2 is input directly to the combiner 108a.

The combiner 108a synthesizes the laser light from the two arrays A1 and A2. The combiner 108a is also referred to as a polarization synthesis element.

The laser light from the combiner 108a is focused by the condenser lenses 104 and 105 toward the end of the optical fiber 107 (not illustrated in the drawing), is coupled optically with the optical fiber 107, and is transmitted though the optical fiber 107. The condenser lenses 104 and 105 are an example of the optical component.

A refrigerant path 109 that cools the subunits 100a (the light-emitting modules 10A), the fiber supporter 106a, the condenser lenses 104 and 105, the combiner 108a, etc., is provided in the base 101. For example, a refrigerant, such as a coolant, flows through the refrigerant path 109. The refrigerant path 109 runs near the surface of the base 101 on which each component is mounted, for example, right under the surface or in the vicinity of the surface, and the inner surface of the refrigerant path 109 and the refrigerant (not illustrated in the drawing) in the refrigerant path 109 are thermally connected to the components and regions to be cooled, that is, the subunits 100a (the light-emitting modules 10A), the fiber supporter 106a, the condenser lenses 104 and 105, the combiner 108a, etc. Heat exchange is performed between the refrigerant and the components and the regions via the base 101 and the components are cooled. Note that an inlet 109a and an outlet 109b of the refrigerant path 109 are provided at an end of the base 101 in the direction opposite to the Y-direction as an example; however, they may be provided in another position.

### Subunit

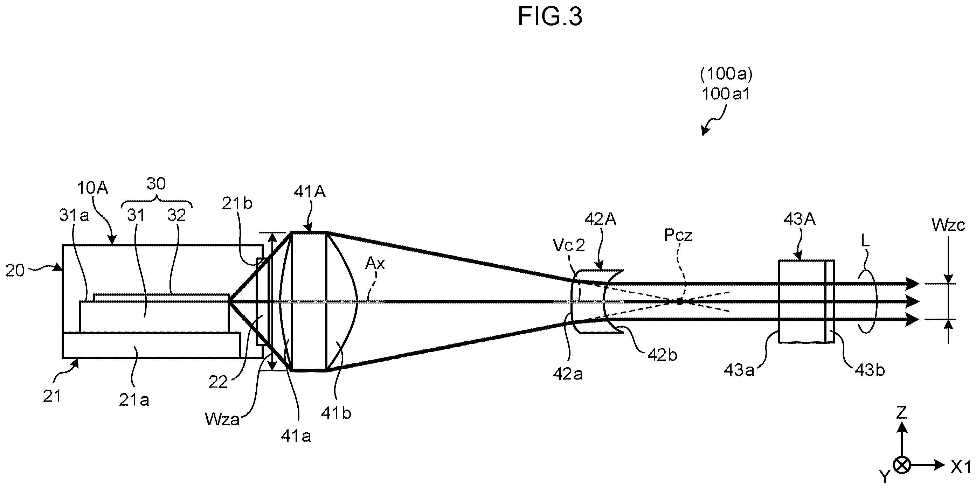

FIG. 3 is a side view illustrating a configuration of the subunit 100a1 (100a). Note that the subunit 100a2 of the array A2 is inverse to the subunit 100a1 in arrangement of optical components and the direction in which laser light is transmitted and however has a similar configuration to that of the subunit 100a1.

The light-emitting module 10A includes a chip-on submount 30 and a case 20 that houses the chip-on submount 30. The case 20 includes a wall part 21 and a window part 22. FIG. 3 illustrates the light-emitting module 10A with the inside of the case 20 being seen through.

The case 20 is a box of a rectangular cuboid and houses the chip-on submount 30. The case 20 includes a wall part 21 and a window part 22. The wall part 21 is made of, for example, a metal material.

The case 20 also includes a base 21a. The base 21a has a platy shape intersecting with the Z-direction. The base 21a is, for example, part (bottom wall) of the wall part 21. The base 21a is made of, for example, a metal material having high thermal conductivity, such as oxygen free copper. Oxygen free copper is an example of the copper material. Note that the base 21a may be provided differently from the wall part 21.

An opening 21b is provided at an end of the wall part 21 in the X1-direction. A window part 22 that transmits laser light L is attached to the opening 21b. The window part 22 intersects with and is orthogonal to the X1-direction. The laser light L that is output from the chip-on submount 30 in the X1-direction passes the window part 22 and goes out of the light-emitting module 10A. The laser light L is output from the light-emitting module 10A in the X1-direction.

A border part between a plurality of parts (not illustrated in the drawing) forming the wall part 21 (the case 20) and a border part between the wall part 21 and the window part 22 are sealed such that a gas cannot pass through. In other words, the case 20 has airtight sealing. Note that that the window part 22 is also part of the wall part 21.

The chip-on-submount 30 includes a submount 31 and a light emitting element 32. The chip-on-submount 30 is also referred to as a semiconductor laser module.

The submount 31 has, for example, a platy shape that intersects with and that is orthogonal to the Z-direction. The submount 31 can be made of, for example, an insulating material having relatively high thermal conductivity, such as aluminum nitride, a ceramic, or glass. A metalized layer 31a is formed on the submount 31 as an electrode that supplies electricity to the light-emitting element 32.

The submount 31 is mounted on the base 21a. The light-emitting element 32 is mounted on a top surface of the submount 31. In other words, the light-emitting element 32 is mounted on the base 21a via the submount 31 and is mounted on the base 101 via the submount 31 and the case 20.

The light-emitting element 32 is, for example, a semiconductor laser device having a fast axis (FA) and a slow axis (SA). The light-emitting element 32 has an elongated shape extending in the X1-direction. The light-emitting element 32 outputs the laser light L in the X1-direction from an emission opening (not illustrated in the drawing) that is provided at an end in the X1-direction. The chip-on submount 30 is mounted such that the fast axis of the light-emitting element 32 is along the Z-direction and the slow axis is along the Y-direction. The Z-direction is an example of a fast-axis direction and the Y-direction is an example of a slow-axis direction.

The laser light L that is output from the light-emitting element 32 goes through the lens 41A, the lens 42A, and the lens 43A in this order and is collimated at least in the Z-direction and the Y-direction. The lens 41A, the lens 42A, and the lens 43A are all provided outside the case 20.

In the present embodiment, the lens 41A, the lens 42A, and the lens 43A are aligned in the X1-direction in this order. The laser light L that is output from the light-emitting element 32 passes through the lens 41A, the lens 42A, and the lens 43A in this order. The laser light L goes out of the light-emitting element 32 and, until the laser light passes the lens 41A, the lens 42A, and the lens 43A, the optical axis of the laser light L is linear, the fast-axis direction of the laser light L is along the Z-direction, and the slow-axis direction of the laser light L is along the Y-direction.

The lens 41A is slightly separate from the window part 22 in the X1-direction or makes contact with the window part 22 in the X1-direction.

The laser light L having passed through the window part 22 is incident on the lens 41A. The lens 41A is a lens having an axisymmetric shape in respect to the center axis Ax along the optical axis and is configured as a part rotating on a center axis Ax. The lens 41A is arranged such that the center axis Ax is along the X1-direction and overlaps the optical axis of the laser light L. Each of an incidence surface 41a and an output surface 41b of the lens 41A has a rotation surface on the center axis Ax extending in the X1-direction. The output surface 41b is a convex surface that is convex in the X1-direction. The output surface 41b protrudes more than the incidence surface 41a. The lens 41A is a so-called convex lens.

The beam width of the laser light L that exits the lens 41A narrows as the laser light L travels in the X1-direction. Note that the beam width is a width of an area where an optical intensity is at or above a given value in a beam profile of the laser light. The given value is, for example, 1/e² of a peak optical intensity. The lens 41A converges the laser light L in the Z-direction, the Y-direction, and a direction between the Z-direction and the Y-direction and therefore an effect that distortion of the laser light L decreases is obtained.

The lens 42A has a plane-symmetrical shape in respect of a virtual center plane Vc2 serving as a plane intersecting with and orthogonal to the Z-direction. An incidence surface 42a and an output surface 42b of the lens 42A have a generatrix along the Y-direction and have a cylindrical surface extending in the Y-direction. The incidence surface 42a is a convex surface that is convex in the direction opposite to the X1-direction. The output surface 42b is a concave surface that is concave in the X1-direction.

The lens 42A collimates the laser light L in the Z-direction, that is, in the fast axis in the state where a beam width Wzc in the Z-direction is smaller than a beam width Wza in the Z-direction on the incidence surface 41a to the lens 41A. The lens 42A is a concave lens on a cross-section orthogonal to the Y-direction. The lens 42A can be also referred to as a collimating lens.

The lens 42A is positioned closer to the lens 41A than a point of convergence Pcz of the laser light L by the lens 41A in the Z-direction. If the lens 42A is positioned farther from the lens 41A than the point of convergence Pcz in the Z-direction, the point of convergence Pcz in the Z-direction will appear on an optical path of the laser light L between the lens 41A and the lens 42A. In this case, there is a risk that a trouble, such as accumulation of dust in the point of convergence Pcz in the Z-direction with a high energy density. In this respect, because the lens 42A is positioned closer to the lens 41A than the point of convergence Pcz in the Z-direction in the present embodiment, the laser light L is collimated by the lens 42A before reaching the point of convergence Pcz. In other words, according to the present embodiment, because the point of convergence Pcz in the Z-direction does not appear on the optical path of the laser light L, it is possible to avoid occurrence of a trouble caused by the point of convergence Pcz.

The point of convergence (not illustrated in the drawing) of the laser light L in the Y-direction appears between the lens 41A and the lens 42A and, because the energy density at the point of convergence in the Y-direction is not so high, a problem, such as accumulation of dust, does not occur.

The beam width of the laser light L having been output from the light-emitting element 32 and having gone through the lens 41A and the lens 42A increases as the laser light L travels in the X1-direction. The flaring laser light L that goes through the lens 42A and widens in the Y-direction is incident on the lens 43A.

The lens 43A has a plane-symmetrical shape in respect of a virtual center plane serving as a plane intersecting with and orthogonal to the Y-direction. An incidence surface 43a and an output surface 43b of the lens 43A have a generatrix along the Z-direction and have a cylindrical surface extending in the Z-direction. The incidence surface 43a is a plane orthogonal to the X1-direction. The output surface 43b is a covex surface that is convex in the X1-direction.

The lens 43A collimates the laser light L in the Y-direction, that is, in the slow axis. The lens 43A is a convex lens in a cross-section orthogonal to the Z-direction. The lens 43A can be also referred to as a collimating lens.

### Inhibition of Adhesive from Changing in Quality

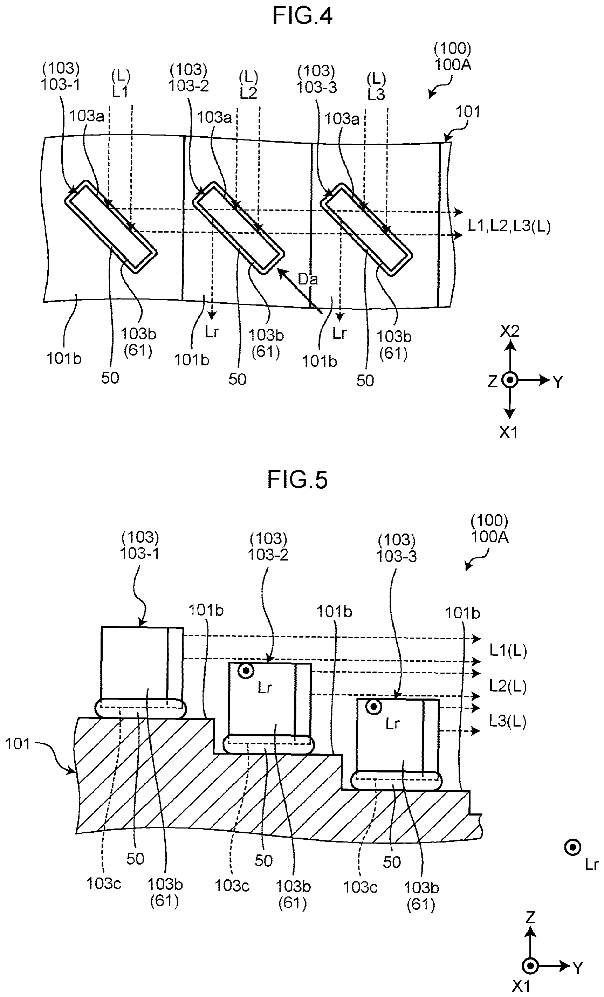

FIG. 4 is a plane view of part of the optical device 100A (100) and FIG. 5 is a side view (partial cross-sectional view) of the optical device 100A (100). FIGS. 4 and 5 illustrate a region containing part of the mirrors 103 contained in the array A1 in the optical device 100A (100). The mirror 103 is an example of a first optical component.

As illustrated in FIG. 5, the faces 101b forming the steps of the base 101 all face in the Z-direction. As described above, the faces 101b form the steps such that the steps are out of alignment in the direction opposite to the Z-direction along the Y-direction. The height of the step between the adjacent faces 101b is approximately constant.

The mirror 103 has a face 103c. The face 103c faces in the direction opposite to the Z-direction and faces the face 101b of the base 101. The face 101b and the face 103c are adhered via an adhesive 50 and accordingly the mirror 103 is attached to the base 101. The Z-direction is an example of a first direction, the face 101b is an example of a first face, and the face 103c is an example of a second face.

For example, ones made of various resin materials, such as epoxy resin, acrylic resin, and silicon resin, are usable as the adhesive 50 and, for example, adhesives that cure because of various effects, such as ultraviolet-curable, thermosetting, ultraviolet-curable and thermosetting, and room-temperature curable ones are usable.

As illustrated in FIG. 4, when viewed in the direction opposite to the Z-direction, the mirrors 103 are aligned in the Y-direction. Each of the mirrors 103 has the face 103a and the face 103b.

The face 103a reflects the laser light L. The body of the mirror 103 is made of, for example, a material that transmits the laser light L, such as optical glass, as an example. In that case, a reflective film that reflects the laser light L is applied to the face 103a. The reflective film is, for example, a metal film. As illustrated in FIGS. 4 and 5, the laser light L that is reflected on the face 103a travels in the Y-direction.

The face 103b is a face on the side opposite to the face 103a. As illustrated in FIG. 4, when viewed in the direction opposite to the Z-direction, the face 103b is a face positioned at an end in the direction opposite to the Y-direction out of the faces 103a and 103b of the mirror 103 overlapping the laser light L traveling in the Y-direction. The face 103b is an example of a third face.

As illustrated in FIG. 5, because of the step structure of the above-described faces 101b, the laser light L reflected on another mirror 103 and traveling in the Y-direction passes over each of the mirrors 103 excluding a mirror 103-1 positioned at the end in the direction opposite to the Y-direction out of the mirrors 103. Specifically, laser light L1 that is reflected on the mirror 103-1 travels in the Y-direction in a position out of alignment in the Z-direction with respect to mirrors 103-2 and 103-3. In other words, the optical axis of the laser light L1 is out of alignment in the Z-direction with respect to the mirrors 103-2 and 103-3. Laser light L2 that is reflected on the mirror 103-2 travels in the Y-direction in a position out of misalignment in the Z-direction with respect to the mirror 103-3. In other words, the optical axis of the laser light L2 is out of alignment in the Z-direction with respect to the mirror 103-3. In this case, the Y-direction is the direction in which laser light travels and is also referred to as a third direction. The Z-direction is also referred to as a second direction.

As for each of the mirrors 103-2 and 103-3, the laser light L that is reflected on the mirror 103 adjacent in the direction opposite to the Y-direction passes nearby the most. A height of the step of the face 101b, a height of the mirror 103, etc., are set such that each mirror 103 and the laser light L that is the nearest to the mirror 103 in the Z-direction interfere as little as possible. The laser light L however has a radial spread on the optical axis and therefore there is a risk that, for example, in a region where the distance between the mirror 103 and the laser light L traveling in the Y-direction is short because of a production tolerance, or the like, a degree at which the laser light L and the mirror L overlap will increase. In that case, there is a risk that, when part of the laser light L interfering with the mirror 103 scatters on an outer surface of the mirror 103, is transmitted through the mirror 103, and reaches the adhesive 50, the adhesive 50 will change in quality due to application of the laser light.

Thus, in the present embodiment, a reflective film 61 is formed on the face 103b. As illustrated in FIGS. 4 and 5, the reflective film 61 reflects the laser light L traveling in the Y-direction in the X1-direction and inhibits the laser light L traveling in the Y-direction from entering the mirror 103. The reflective film 61 is an example of a first inhibitor. Note that the reflected light of the laser light L traveling in the Y-direction on the reflective film 61 is referred to as Lr. The configuration including the reflective film 61 inhibits the laser light L traveling in the Y-direction from entering the mirror 103, being transmitted through the mirror 103, and reaching the adhesive 50. The reflective film 61 is an example of an inhibitor.

On the face 103b of the mirror 103, an area with a risk of interference with the laser light L is an area of an end in the Z-direction and the direction toward the adhesive from the area is a direction opposite to the approximate Z-direction. The X1-direction in which reflected light Lr travels is a direction different from the direction opposite to the approximate Z-direction and is a direction not toward the adhesive 50. The reflective film 61 is an example of a first reflector.

As described above, in the present embodiment, providing the reflective film 61 on the face 103b of the mirror 103 makes it possible to inhibit the laser light traveling in the Y-direction from partly interfering with the mirror 103, being transmitted through the mirror 103, and reaching the adhesive 50 and inhibit the adhesive 50 from changing in quality. Thus, according to the present embodiment, an effect that it is possible to inhibit the adhesive 50 from changing in quality and further increase reliability in adhesion with the adhesive 50 is obtained.

In this case, it is also possible to form the reflective film 61 concurrently in the same process as that for the reflective film that is formed on the face 103a. In other words, according to the present embodiment, because it is possible to form the reflective film 61 in the process of forming the reflective film on the face 103a of the mirror 103, an effect that it is possible to reduce the work and time of manufacturing compared to the case where the reflective films are formed in different processes, respectively, and eventually reduce the manufacturing cost is also obtained.

### Second Embodiment

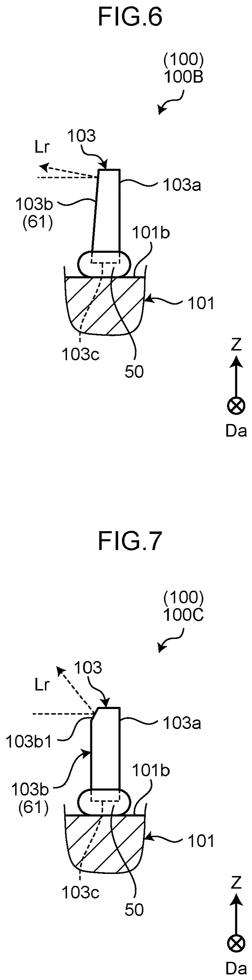

FIG. 6 is a side view (partial cross-sectional view) of part of an optical device 100B (100) of a second embodiment and is a view of the mirror 103 viewed in a direction equal to a Da-direction in FIG. 4.

The optical device 100B of the present embodiment has a configuration similar to that of the first embodiment. Note that, in the present embodiment, the shape of the mirror 103 is different from that of the above-described first embodiment. Specifically, as illustrated in FIG. 6, a normal direction of the face 103b of the mirror 103 has a component in the Z-direction and the face 103b is entirely oblique to the Z-direction. In this case, the reflected light Lr on the reflective film 61 travels in the direction of separation from the adhesive 50. According to the present embodiment, it is thus possible to inhibit the reflected light Lr from reaching the adhesive 50 more assuredly and inhibit the adhesive 50 from deteriorating due to the laser light L more assuredly.

### Third Embodiment

FIG. 7 is a side view (partial cross-sectional view) of part of an optical device 100C (100) of a third embodiment and is a view of the mirror 103 viewed in a direction equal to the Da-direction in FIG. 4.

The optical device 100C of the present embodiment has a configuration similar to that of the second embodiment. Note that, in the present embodiment, the shape of the mirror 103 is different from that of the above-described second embodiment. Specifically, the face 103b is not oblique to the Z-direction entirely as in the second embodiment but is oblique to the Z-direction only at an end 103b1 in the Z-direction. The normal direction of the end 103b1 has a component in the Z-direction. In this case, the reflected light Lr on the reflective film 61 that is provided at the end 103b1 travels in a direction of separation from the adhesive 50. Also according to the present embodiment, it is thus possible to more assuredly inhibit the reflected light Lr from reaching the adhesive 50 and more assuredly inhibit the adhesive 50 from deteriorating due to the laser light. According to the present embodiment, an effect that it is possible to process the mirror 103 more easily compared to the second embodiment is obtained.

### Fourth Embodiment

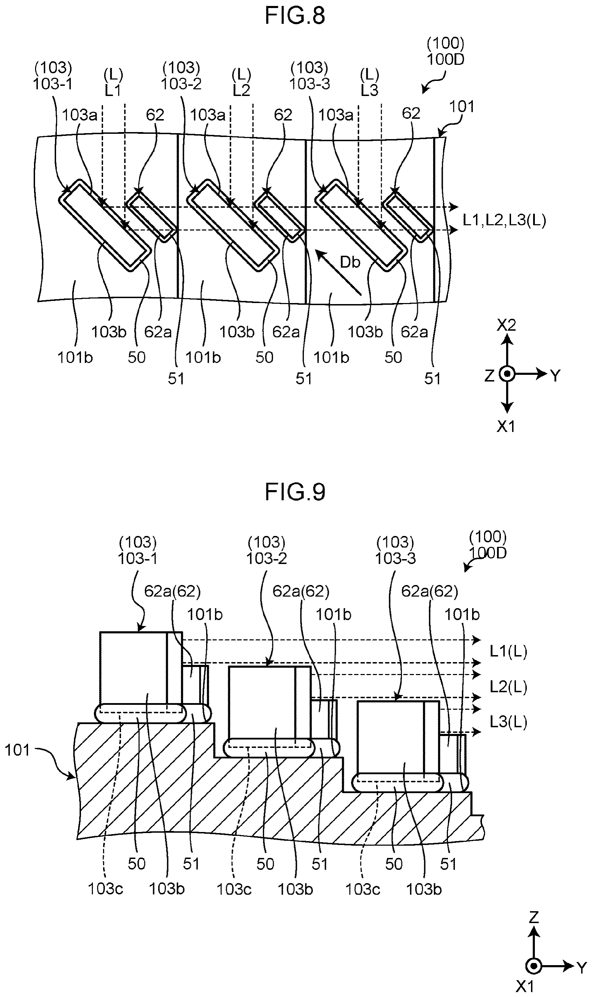

FIG. 8 is a plane view of part of an optical device 100D (100) of a fourth embodiment and FIG. 9 is a side view (partial cross-sectional view) of part of the optical device 100D (100). FIGS. 8 and 9 illustrate a region containing part of the mirrors 103 contained in the array A1 in the optical device 100D (100).

The present embodiment includes, in addition to the mirror 103, a mirror 62 that inhibits the laser light L traveling in the Y-direction from entering the mirror 103. As illustrated in FIG. 9, the mirror 62 is adhered onto the face 101b via an adhesive 51. The mirror 62 is provide out of alignment in the direction opposite to the Y-direction with respect to the mirror 103 (simply referred to as the corresponding mirror below) on which the laser light L traveling in the Y-direction is to be inhibited from entering.

In the present embodiment, the face 101b to which each mirror 62 is attached is a face out of alignment in the direction opposite to the Y-direction with respect to the faces 101b on which the corresponding mirrors 103-2 and 103-3 are attached. The face 101b to which each mirror 62 is attached is an example of a fourth face.

In each mirror 62, a face 62a on the side opposite to the corresponding mirrors 103-2 and 103-3 reflects the laser light L. The face 62a may be provided with a reflective film. In this case, a reflective film may be provided entirely on a peripheral surface (side surface) of the mirror 62.

The positions of the ends of the respective mirrors 62 in the Z-direction are set approximately the same as the positions of the ends of the corresponding mirrors 103-2 and 103-3 in the Z-direction. According to such a configuration, the mirror 62 prevents travel of only part of the laser light L traveling in the Y-direction with a risk of entering the corresponding mirrors 103-2 and 103-3. The mirror 62 is an example of a first part and is an example of the inhibitor, the first inhibitor, and the first reflector.

Also according to the present embodiment, an effect that it is possible to inhibit the adhesive 50 from changing in quality and further increase reliability in adhesion with the adhesive 50 is obtained.

### Fifth Embodiment

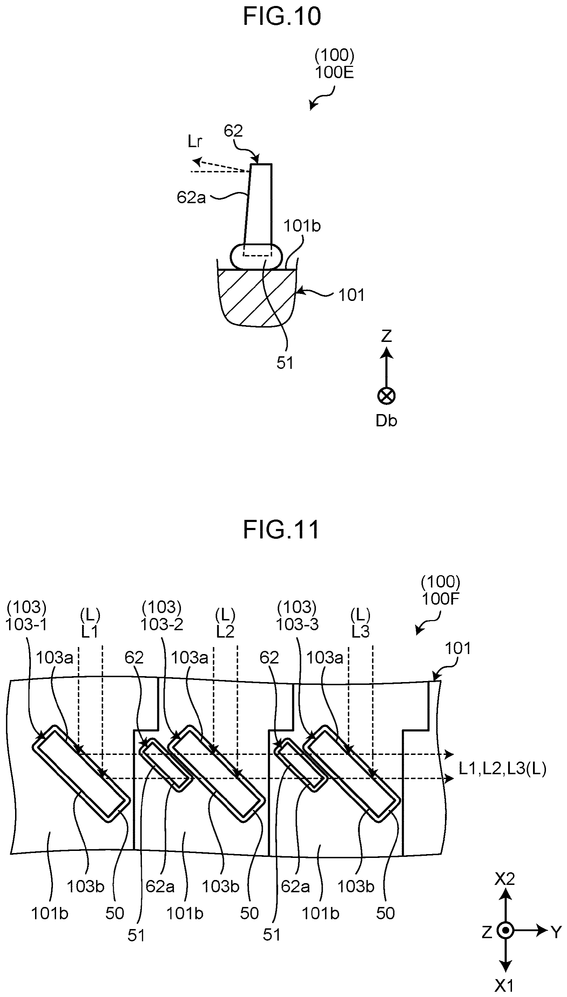

FIG. 10 is a side view (partial cross-sectional view) of part of an optical device 100E (100) of a fifth embodiment and is a view of the mirror 62 viewed in a direction equal to a Db-direction in FIG. 8.

The optical device 100E of the present embodiment has a configuration similar to that of the fourth embodiment. Note that, in the present embodiment, the shape of the mirror 62 is different from that of the above-described fourth embodiment. Specifically, as illustrated in FIG. 10, a normal direction of the face has a component in the Z-direction and the face 62a is oblique to the Z-direction entirely. In this case, the reflected light Lr on the face 62a travels in a direction of separation from the adhesive 50. Also according to the present embodiment, it is thus possible to more assuredly inhibit the reflected light Lr from reaching the adhesive 50 and more assuredly inhibit the adhesive 50 from deteriorating due to the laser light L. Note that the shape of the mirror 62 is not limited to the shape in FIG. 10 and, for example, the shape may be a shape whose normal direction has a component of the Z-direction only at an end in the Z-direction as in the mirror 103 in FIG. 7.

### Sixth Embodiment

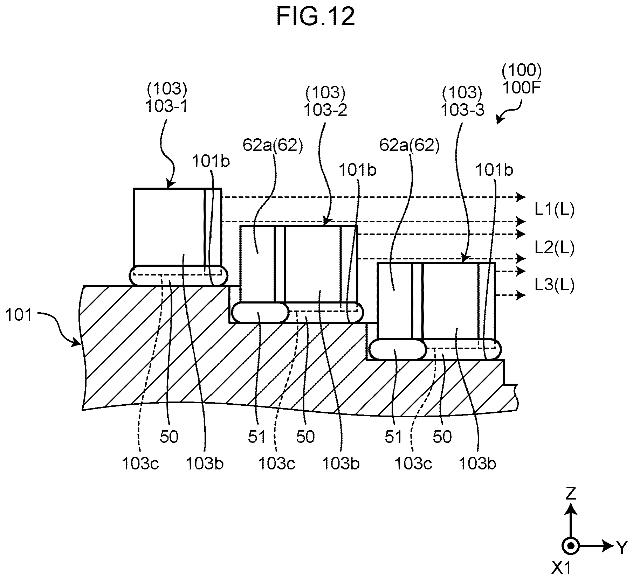

FIG. 11 is a plane view of part of an optical device 100F (100) of a sixth embodiment and FIG. 12 is a side view (partial cross-sectional view) of the optical device 100F (100). FIGS. 11 and 12 illustrate a region containing part of the mirrors 103 contained in the array A1 in the optical device 100F (100).

The optical device 100F of the present embodiment has a configuration similar to that of the fourth embodiment. Note that, in the present embodiment, the position of the mirror 62 is different from that of the above-described fourth embodiment. Specifically, the mirror 62 is not attached to the face 101b different from the face 101b to which the corresponding mirror 103 is attached but is attached to the face 101b to which the corresponding mirror 103 is attached. Except for the difference of the face 101b of the attachment, the optical device 100F of the present embodiment has the same configuration as that of the optical device 100D of the above-described fourth embodiment.

Also according to the present embodiment, an effect that it is possible to inhibit the adhesive 50 from changing in quality and further increase reliability in adhesion with the adhesive 50 is obtained.

### Seventh Embodiment

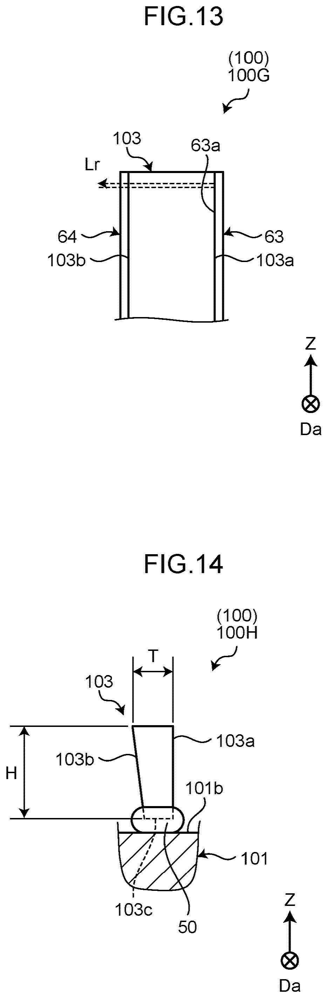

FIG. 13 is a side view of part of an optical device 100G (100) of a seventh embodiment and is a view of the mirror 103 viewed in a direction equal to the Da-direction in FIG. 4.

The optical device 100G of the present embodiment has a configuration similar to that of the above-described first embodiment. Note that the present embodiment is different from the above-described first embodiment in the configuration of the mirror 103. Specifically, first of all, the face 103b of the mirror 103 is provided with a reflective-preventive film 64. The reflective-preventive film 64 inhibits the laser light L from scattering on the face 103b and thus makes it possible to inhibit scattering laser light from being transmitted through the mirror 103 and reaching the adhesive 50. The reflective-preventive film 64 is an example of the inhibitor and a second inhibitor and the face 103b is an example of a fifth face.

The face 103a of the mirror 103 is provided with a reflective film 63 that reflects the laser light L traveling in the X1-direction in the Y-direction. The reflective film 63 is configured such that laser light having transmitted through the reflective-preventive film 64 and having entered the mirror 103 is reflected on a back face 63a of the reflective film 63. The reflected light Lr on the back face 63a travels in a direction opposite to a normal direction of the back face 63a, that is, a direction intersecting with the Z-direction. The direction toward the adhesive 50 from an area that reflects the laser light on the back face 63a is the direction opposite to the approximate Z-direction. The direction in which the reflected light Lr travels is a direction different from the direction opposite to the approximate Z-direction and is a direction not toward the adhesive 50. The reflective film 63 is an example of a second reflector and is an example of the inhibitor and a third inhibitor. The face 103a is an example of a sixth face and the face 103b is an example of a seventh face.

The reflective-preventive film 64 is referred to as an area having higher transmissivity to the laser light L than that of other outer surfaces of the mirror 103. The reflective-preventive film 64 is an example of a first area. Note that implementing mirror finishing on the face 103b instead of the reflective-preventive film 64 may lower surface roughness more than other outer surfaces of the mirror 103 and inhibit scattering on the face 103b and increase transmissivity. In this case, the area on which mirror finishing is implemented is an example of the inhibitor and the second inhibitor and is an example of the first area. The area on which mirror finishing is implemented can be also referred to as a low surface-roughness area and a mirror area.

### Eighth Embodiment

FIG. 14 is a side view (partial cross-sectional view) of part of an optical device 100H (100) of an eighth embodiment and is a view of the mirror 103 viewed in a direction equal to the Da-direction in FIG. 4.

The intensive studies by the inventors found that, even in the case where the laser light L traveling in the Y-direction enters the mirror 103, when a heigh H of the mirror 103 that is a point of interference of laser light is at or above a given value or when a maximum thickness T of the mirror 103 is at or under a given value, scattering and absorption on the faces 103a and 103b and absorption in the mirror 103 make it possible to attenuate the laser light to a degree at which there is almost no effect on the adhesive 50. The height H is a height in a normal direction of the face 101b, that is, in the Z-direction and the maximum thickness T is a maximum thickness in a normal direction of the face 103a.

Specifically, it was found that the height H is preferably 1.8 mm or larger and is more preferably 2.0 mm or larger. It was found that the maximum thickness T is preferably 1.1 mm or smaller and is more preferably 0.8 mm or smaller. It was also found that, even when the height H is smaller than 1.8 mm, setting the maximum thickness T at 0.8 mm or smaller makes it possible to inhibit a change of the adhesive 50 in quality to a level at which there is almost no problem.

In the present embodiment, the normal direction of the face 103b of the mirror 103 has a component in the direction opposite to the Z-direction and the face 103b is entirely oblique to the Z-direction. In this case, when the laser light is transmitted in the mirror 103, because the scattering light on the face 103b tends to travel in a direction of separation from the adhesive 50 and enables a long length of the path in which the laser light is transmitted in the mirror 103, it is possible to promote attenuation of the laser light and further inhibit the adhesive 50 from changing in quality due to the laser light.

The embodiments of the present invention are exemplified above and the above-described embodiments are examples and are not intended to limit the scope of the invention. It is possible to carry out the above-described embodiments in other various modes and various omissions, replacements, combinations and changes without departing from the scope of the invention. It is possible to change and practice the specification, such as each configuration and shape, (structure, type, direction, model, size, length, width, thickness, height, number, arrangement, position, material, etc.,) as appropriate.

For example, an absorptive film that absorbs laser light may be provided instead of the reflective film of the above-described embodiment or a part that absorbs laser light may be provided instead of a part (first part) that reflects laser light. In this case, the absorptive film or the absorptive part are an example of an absorber and is an example of the inhibitor and the first inhibitor. The absorptive part is an example of a second part. The quality of the absorptive film and the absorptive part may be selected as appropriate according to the wavelength of laser light, and the like.

The first inhibitor may be provided in a protrusion that is part of the base and that protrudes from, for example, the first face or the fourth face of the base instead of the part (first part) that is attached to the base and that reflects laser light or the part (second part) that absorbs the laser light. In this case, there is an advantage that, compared to the configuration in which the part forming the first inhibitor is attached to the base, the process of attaching the part to the base can be omitted and accordingly the work and time required to manufacture the optical device can be reduced.

The optical component is not limited to those disclosed in the embodiment, and it may be, for example, an optical component different from a mirror, such as a lens, a prism, or a diffraction optical element.

In the above-described embodiment, the second direction is the same direction as the first direction; however, the second direction is not limited to this, and the second direction may be a direction different from the first direction. In that case, the second direction can be defined as a direction from a point positioned in the shortest distance to an optical axis of laser light passing by the optical component among points on the outer surface of the optical component toward the optical axis of the laser light and is a direction orthogonal to the optical axis.

### Industrial Applicability

It is possible to use the present invention for an optical device.

### Reference Signs List

10A LIGHT-EMITTING MODULE
20 CASE
21 WALL PART
21a BASE
21b OPENING
22 WINDOW PART
30 CHIP-ON SUBMOUNT
31 SUBMOUNT
31a METALIZED LAYER
32 LIGHT-EMITTING DEVICE
41A LENS
41a INCIDENCE SURFACE
41b OUTPUT SURFACE
42A LENS
42B LENS
42a INCIDENCE SURFACE
42b OUTPUT SURFACE
43A LENS
43a INCIDENCE SURFACE
43b OUTPUT SURFACE
50 ADHESIVE
51 ADHESIVE
61 REFLECTIVE FILM (FIRST REFLECTOR, FIRST INHIBITOR, INHIBITOR)
62 MIRROR (FIRST PART, FIRST REFLECTOR, FIRST INHIBITOR, INHIBITOR)
62a FACE
63 REFLECTIVE FILM (SECOND REFLECTOR, THIRD INHIBITOR, INHIBITOR)
63a BACK FACE
64 REFLECTIVE-PREVENTIVE FILM (FIRST AREA, SECOND INHIBITOR, INHIBITOR)
100, 100A TO 100H OPTICAL DEVICE
100a, 100a1, 100a2 SUBUNIT
101 BASE
101b FACE (FIRST FACE, FOURTH FACE)
101c SHIELD
103, 103-1 TO 103-3 MIRROR (OPTICAL COMPONENT, FIRST OPTICAL COMPONENT)
103a FACE (SIXTH FACE)
103b FACE (THIRD FACE, FIFTH FACE, SEVENTH FACE)
103b1 END
103c FACE (SECOND FACE)
104 CONDENSER LENS
105 CONDENSER LENS
106a FIBER SUPPORTER
107 OPTICAL FIBER
108 OPTICAL SYNTHESIZER
108a COMBINER
108b MIRROR
108c 1/2 WAVE PLATE
109 REFRIGERANT PATH
109a INLET
109b OUTLET
A1 ARRAY
A2 ARRAY
AX CENTER AXIS
H HEIGHT
L, L1, L2 LASER LIGHT
Lr REFLECTED LIGHT
Pcz POINT OF CONVERGENCE
T MAXIMUM THICKNESS
Vc2 VIRTUAL CENTER PLANE
WZa BEAM WIDTH
WZC BEAM WIDTH
X1 DIRECTION
X2 DIRECTION
Y DIRECTION
Z DIRECTION (FIRST DIRECTION)

## Claims

1. An optical device comprising:
a base including a first face facing in a first direction;
an optical component having a second face that faces the first face and that is adhered to the first face with an adhesive; and
an inhibitor that inhibits part of laser light an optical axis of which is out of alignment with the optical component from reaching the adhesive.

2. The optical device according to claim 1, wherein a first inhibitor that inhibits the laser light from entering the optical component is provided as the inhibitor.

3. The optical device according to claim 2, wherein a first reflector that reflects the laser light in a direction not toward the adhesive is provided as the first inhibitor.

4. The optical device according to claim 3, wherein the first reflector is provided on a third face that is positioned at an end of the optical component in a direction opposite to a direction in which the laser light travels.

5. The optical device according to claim 4, wherein the first reflector has a reflective film that is provided on the third face.

6. The optical device according to any one of claims 3 to 5, wherein the first reflector reflects the laser light in a direction intersecting with a direction opposite to a direction in which the laser light travels.

7. The optical device according to claim 3, wherein the first reflector is provided on a first part that is attached to the base.

8. The optical device according to claim 7, wherein the first part is attached to the first face.

9. The optical device according to claim 7, comprising a fourth face facing in the first direction at a position out of alignment in a direction opposite to a direction in which the laser light travels with respect to the first face, and
the first part is attached to the fourth face.

10. The optical device according to claim 2, wherein an absorber that absorbs the laser light is provided as the first inhibitor.

11. The optical device according to claim 10, wherein the absorber is provided on a third surface that is positioned at an end of the optical component in a direction opposite to a direction in which the laser light travels.

12. The optical device according to claim 11, wherein the absorber is provided on a second part that is attached to the base.

13. The optical device according to claim 2, wherein the first inhibitor is provided on a protrusion that is part of the base and that protrudes from the base.

14. The optical device according to claim 1, wherein a second inhibitor that is provided on a fifth face on which the laser light enters the optical component and that inhibits laser light from scattering is provided as the inhibitor.

15. The optical device according to claim 1, wherein a third inhibitor that inhibits the laser light from being transmitted to the adhesive in the optical component when the laser light enters the optical component is provided as the inhibitor.

16. The optical device according to claim 15, wherein the third inhibitor is provided on a back surface of a reflective film that covers a sixth face serving as an outer surface of the optical component.

17. The optical device according to claim 15 or 16, wherein a second reflector that reflects laser light that enters the optical component in a direction not toward the adhesive is provided as the third inhibitor.

18. The optical device according to claim 16, wherein, in a seventh face that serves as an outer surface of the optical component and that transmits the laser light toward the sixth face, a first area having higher transmissivity to the laser light than other outer surfaces of the optical component is provided.

19. The optical device according to claim 18, wherein a reflective-preventive film is provided in the first area.

20. The optical device according to claim 18, wherein the first area is an area having a surface roughness lower than other outer surfaces.

21. The optical device according to claim 1, wherein
a plurality of first optical components are provided as the optical component,
a plurality of faces that are out of alignment in a direction in which the laser light travels and that form steps that are output alignment in a direction opposite to the first direction toward the direction in which the laser light travels are provided as the first face, and
the optical axis is out of alignment in the first direction with respect to the plurality of faces.
